(19)

**Europäisches Patentamt**

**European Patent Office**

**Office européen des brevets**

(11) **EP 4 746 226 A1**

(12) **EUROPEAN PATENT APPLICATION**

(43) Date of publication:
    **20.05.2026 Bulletin 2026/21**

(21) Application number: **25199812.6**

(22) Date of filing: **03.09.2025**

(51) International Patent Classification (IPC):
    **H02J 3/01** (2026.01)    **G01R 19/25** (2006.01)
    **G06F 17/14** (2006.01)    **H02J 13/12** (2026.01)

(52) Cooperative Patent Classification (CPC):
    **H02J 3/01; G01R 19/2513; G01R 23/16;**
    **G06F 17/141;** G06F 17/142; H02J 13/12

(84) Designated Contracting States:
    **AL AT BE BG CH CY CZ DE DK EE ES FI FR GB**
    **GR HR HU IE IS IT LI LT LU LV MC ME MK MT NL**
    **NO PL PT RO RS SE SI SK SM TR**
    Designated Extension States:
    **BA**
    Designated Validation States:
    **GE KH LA MA MD TN**

(30) Priority:   **03.09.2024   US 202463690000 P**

(71) Applicant: **Eaton Intelligent Power Limited**
    **Dublin 4 (IE)**

(72) Inventor: **COX, ROGER W.**
    **McDonald, 15057-2189 (US)**

(74) Representative: **Derry, Paul Stefan et al**
    **Venner Shipley LLP**
    **200 Aldersgate**
    **London EC1A 4HD (GB)**

(54) **SYSTEMS AND METHODS FOR MONITORING  SUB-SYNCHRONOUS OSCILLATIONS**

(57)    A sub-synchronous oscillation (SSO) management system for an electrical power system is described. The SSO management system may be associated with a power quality meter connected to a power source and a plurality of loads. The SSO management system includes a Fourier analyzer to perform Fast Fourier transform (FFT) on a power waveform over a time window based on power quality data received from the power quality meter. A peak identifier may operate to identify one or more peaks above a threshold from a set of FFT bins. An amplitude determiner may operate to obtain an amplitude at each detected SSO frequency including root mean square (RMS) values from a plurality of adjacent FFT bins within a range of interest. The SSO management system may detect SSO and perform control processes to mitigate or even eliminate SSO via a damping system, control of power distribution apparatuses, and/or parameter tuning.

**Description**

CROSS REFERENCE TO RELATED APPLICATIONS

This application claims priority to U.S. Provisional Patent Application Serial No. 63/690,000, filed on September 3, 2025 and titled "SYSTEM AND METHOD FOR CONTINUOUS MONITORING OF SUB-SYNCHRONOUS OSCILLATIONS," the disclosure of which is incorporated herein by reference.

TECHNOLOGICAL FIELD

The present disclosure is directed to systems and methods for operating a power distribution system, and, in particular, to management of a power distribution system based on sub-synchronous oscillation (SSO).

BACKGROUND

Sub-synchronous oscillation (SSO) is an electro-mechanical resonance phenomenon in an electrical power system where the frequency of the electrical oscillation is less than the fundamental frequency of the system. For example, when the fundamental frequency of the system is 60 Hz, SSO is an oscillation less than 60 Hz (for instance, in the range of 2 - 55 Hz). An SSO can be caused by power distribution equipment, for example, interaction between generators and series-compensated lines, turbine-generator shaft torsional interactions, control system dynamics, and/or other causes. Unless mitigated, an SSO may lead to instability and potential damage to the electrical equipment and circuitry. For instance, continuous SSOs may lead to fatigue and potential failure of turbine-generator shafts. Uncontrolled SSOs may lead to system-wide instability, resulting in blackouts. In order to mitigate the effects of SSO, numerous approaches have been attempted to monitor and mitigate SSO, including use of damping devices, control system modifications, and operational parameter changes. The growing complexity and energy demands of power distribution systems has added to the challenges of monitoring SSO. For instance, increased use of renewable energy systems, such as inverter-based connections from solar and wind systems has complicated the analysis of SSOs. In addition, varying loads of high-demand power consumers, such as datacenters, warehouses, and manufacturing facilities, which require power-electronics-based devices and high computational capabilities, have complicated the SSO analysis even further.

SUMMARY

This Summary is provided to introduce a selection of concepts in a simplified form that are further described below in the Detailed Description. This Summary is not intended to identify key features or essential features of the claimed subject matter, nor is it intended as an aid in determining the scope of the claimed subject matter.
In one example, an electrical power system may include a plurality of electrical distribution equipment configured to distribute power between at least one power source and a plurality of loads; a power quality meter configured to measure power quality data for power distributed via the plurality of electrical distribution equipment; and a sub-synchronous oscillation (SSO) management system operative to detect SSO within the electrical power system. The SSO management system may be operative to access power waveform information of the power quality data, perform Fast Fourier transform (FFT) on the power waveform over a time window for a resolution target for a number of samples to compute FFT information comprising a plurality of frequency domain bins comprising a bin for each of the number of samples, identify at least one SSO peak above a peak threshold from the frequency domain bins, and determine a presence of SSO based on the at least one SSO peak.
In some embodiments of the electrical power system, the at least one SSO peak is identified within a range of bins of the plurality of frequency domain bins based on a frequency range of interest.
In various embodiments of the electrical power system, the frequency range of interest is about 2 Hz to about 20 Hz.
In some embodiments of the electrical power system, the power quality data comprises half-cycle input data including half-cycle RMS voltage data, half-cycle RMS current data, and half-cycle RMS power data.
In various embodiments of the electrical power system, the SSO management system is operative to calculate an amplitude at each SSO frequency from a bin range of the plurality of frequency domain bins.
In exemplary embodiments of the electrical power system, the amplitude comprises root mean square (RMS) values from a plurality of surrounding FFT bins within the bin range.
In various embodiments of the electrical power system, the number of samples is based on the resolution target. In some embodiments of the electrical power system, the resolution target is 0.1 Hz. In various embodiments of the electrical power system, the number of samples is 2048 samples.
In some embodiments of the electrical power system, a plurality of FFTs are performed over a sliding window to determine SSO bursts.

In various embodiments of the electrical power system, the SSO management system is operative to control the operation of a distribution appliance to mitigate SSO.

In one example, a power quality meter (PQM) may include at least one sensor operative to measure power information to determine power quality data for power distributed via a plurality of electrical distribution equipment of an electrical power system, the power quality data comprising power waveform information; and a sub-synchronous oscillation (SSO) management system. The SSO management system may be operative to compute FFT information by performing Fast Fourier transform (FFT) on the power waveform over a time window for a resolution target for a number of samples, the FFT information comprising a plurality of frequency domain bins comprising a bin for each of the number of samples, identify at least one SSO peak above a peak threshold from the frequency domain bins, and determine a presence of SSO based on the at least one SSO peak.

In some embodiments of the PQM, the at least one SSO peak is identified within a range of bins of the plurality of frequency domain bins based on a frequency range of interest.

In various embodiments of the PQM, the power quality data comprises half-cycle input data including half-cycle RMS voltage data, half-cycle RMS current data, and half-cycle RMS power data.

In some embodiments of the PQM, the SSO management system is operative to calculate an amplitude at each SSO frequency from a bin range of the plurality of frequency domain bins.

In various embodiments of the PQM, the amplitude comprises root mean square (RMS) values from a plurality of surrounding FFT bins within the bin range.

In some embodiments of the PQM, the SSO management system is operative to control the operation of a distribution appliance to mitigate SSO.

In one example, a sub-synchronous oscillation (SSO) management system may include at least one memory storing instructions and at least one processor circuitry, communicatively coupled to the at least one memory, operative to execute the instructions to: access power waveform information of the power quality data, perform Fast Fourier transform (FFT) on the power waveform over a time window for a resolution target for a number of samples to compute FFT information comprising a plurality of frequency domain bins comprising a bin for each of the number of samples, identify at least one SSO peak above a peak threshold from the frequency domain bins, and determine a presence of SSO based on the at least one SSO peak.

In some embodiments of the SSO management system, the power quality data comprises half-cycle input data including half-cycle RMS voltage data, half-cycle RMS current data, and half-cycle RMS power data.

In various embodiments of the SSO management system, the at least one processor circuitry is operative to execute the instructions to control the operation of a distribution appliance to mitigate SSO.

Some embodiments provide a sub-synchronous oscillation (SSO) monitor for an electrical power system having a power quality meter connected to a power source and a plurality of loads. The SSO monitor includes: a Fourier analyzer structured to perform Fast Fourier transform (FFT) on a power waveform over a latest time window based on a power quality data received from the power quality meter; a peak identifier structured to identify one or more peaks above a threshold from FFT bins; and an amplitude determiner structured to obtain amplitude at each detected SSO frequency including root mean square (RMS) values from a plurality of adjacent FFT bins within a range of interest.

Another example embodiment includes a plurality of loads including a datacenter and one or more distributed energy resource; a power source having a fundamental frequency structured to provide power to the loads; and a main power center including a power quality meter and a sub-synchronous oscillation (SSO) monitor, the power quality meter structured to receive data from each load, monitor an overall power quality of the electrical power system based at least in part on the data, and transmit power quality data to the SSO monitor. The SSO monitor includes: a Fourier analyzer structured to perform Fast Fourier transform (FFT) on a power waveform over a latest time window based on the power quality data received from the power quality meter; a peak identifier structured to identify one or more peaks above a threshold from FFT bins; and an amplitude determiner structured to obtain amplitude at each detected SSO frequency including root mean square (RMS) values from a plurality of adjacent FFT bins within a range of interest.

Another example embodiment includes a method for monitoring a sub-synchronous oscillation (SSO) in an electrical power system having a power quality meter connected to a power source and a plurality of loads. The method includes: receiving a power quality data from the power quality meter, the power quality data including half-cycle root means square (RMS) values and monitoring the SSO based on the half-cycle RMS values.

BRIEF DESCRIPTION OF THE DRAWINGS:

A full understanding of the invention can be gained from the following description of the preferred embodiments when read in conjunction with the accompanying drawings in which:

FIG. 1 depicts an illustrative example of an operating environment in accordance with the present disclosure;

FIG. 2 depicts an illustrative example of a sub-synchronous oscillation (SSO) management system in accordance with the present disclosure;

FIGS. 3-6 illustrate continuous SSO detection within an electrical power system in accordance with the present disclosure;

FIGS. 7-9 illustrate a burst of SSO detected within the electrical power system of Figure 1 in accordance with the present disclosure;

FIGS. 10-12 illustrate a plurality of SSO bursts detected within the electrical power system in accordance with the present disclosure;

FIGS. 13-16 illustrate a plurality of bursts having different SSO frequencies detected within the electrical power system in accordance with the present disclosure; and

FIG. 17 illustrates a logic flow in accordance with the present disclosure.

DETAILED DESCRIPTION

Various features of improved sub-synchronous oscillation (SSO) management systems are described in the present disclosure, with reference to the accompanying drawings, in which one or more features of an SSO management system are shown and described. The various features described in the present disclosure and depicted in the accompanying drawings may be used independently of, or in combination with, each other. An SSO management system as disclosed herein may be embodied in many different forms and should not be construed as being limited to the examples set forth herein. Rather, these examples are provided to convey certain features of the SSO management system to those skilled in the art.

Directional phrases used herein, such as, for example, left, right, front, back, top, bottom and derivatives thereof, relate to the orientation of the elements shown in the drawings and are not limiting upon the claims unless expressly recited therein.

As employed herein, the statement that two or more parts or components are "coupled" shall mean that the components are joined or operate together either directly or indirectly, for instance, through direct contact, through one or more intermediate parts or components, and/or through the communication or flow of data, electricity, current, and/or the like between the components (e.g., "communicatively coupled" or "electrically coupled).

As employed herein, ordinal terms such as "first" and "second" are used to distinguish one item from another, and are not intended to require a sequential order unless specifically stated.

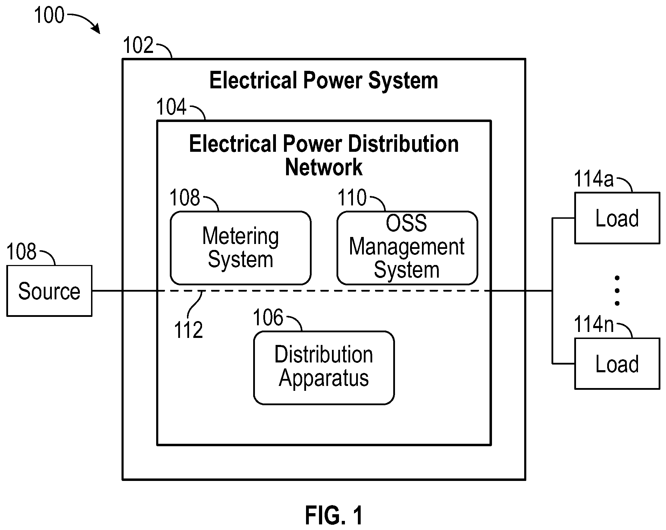

FIG. 1 illustrates a first exemplary operating environment in accordance with the present disclosure. As shown in FIG. 1, an operating environment 100 may include an electrical power system 102. The electrical power system 102 includes an electrical power distribution network 104 that transfers electricity from a power source 108 to electrical loads 1114a-n through a distribution path 112 and distribution apparatus 106, for example, transformers, voltage regulators, inverters, converters, phase-locked loops and/or the like. In various embodiments, the distribution apparatus 106 may include one or more computing devices or systems configured to control operational aspects of the power distribution center, for instance, changing operating parameters, turn equipment on/off, change distribution routing, and/or the like.

The distribution path 112 may include, for example, one or more transmission lines, electrical cables, electrical busses, and/or any other mechanism for transmitting electricity. The loads 114a-n may include, for example and without limitation, lighting, a motor control center (MCC), a datacenter (for instance, an AI datacenter requiring a significant amount of computing power), a warehouse, a manufacturing facility, residential power consumers, industrial power consumers, an inverter-based distributed energy resources (DERs) (for instance, solar and wind farms connected to the electrical power system 102 via inverter connections), and/or the like.

The distribution network 104 may be, for example, an electrical grid, an electrical system, or a multi-phase electrical network that provides electricity to commercial and/or residential customers. In some embodiments, the power distribution network 104 may be an AC power system. In various embodiments, the power distribution network 104 may be a multi-phase AC system, such as a three-phase system. The distribution network 104 may operate at one or more system frequencies of, for example and without limitation, about 50 Hertz (Hz), about 60 Hz, about 50 Hz to about 60 Hz. In some embodiments, the distribution network 104 may operate at a system frequency about 60 Hz.

In some embodiments, the distribution network 104 may be or may include a main power center connected to the power source 108 and structured to feed and control power supply to the loads 114a-n. The distribution network 104 may be, for example and without limitation, a load center for industrial or commercial facilities. The distribution network 104 may include a metering system 108 and a sub-synchronous oscillations (SSO) management system 110.

In various embodiments, the metering system 108 may be configured to measure, monitor, and store operational data related to the power distribution by the electrical power system 102 and components thereof. In some embodiments, the metering system 108 may monitor power information including current, voltage, power frequencies, power waveforms, harmonics, power factor, transients, and/or the like. In some embodiments, the metering system 108 may include a plurality of individual meters arranged to measure power distribution information at various locations within the electrical power system.

In various embodiments, the metering system 108 may be or may include a power quality meter (PQM) structured to receive data from each load 114a-n and monitor an overall power quality of the electrical power system 102 based at least in part on the data. A PQM may include one or more existing PQMs known to those of skill in the art and/or future developed PQMs. In various embodiments, a PQM may include a device designed to the IEC 61000-4-30 standard. In some embodiments, a PQM may be a device the same or similar to a PQM or PQM systems provided by Eaton Corporation PLC of Dublin, Ireland including, without limitation, a Power XPert Meter and/or a PQM compatible with the PXQ Event Analysis System.

In some embodiments, the power information may be or may include power quality data. In various embodiments, the power quality data may be or may include root mean square (RMS) voltage, current, and power with half-cycle updates (e.g., half-cycle input data). In exemplary embodiments, the power quality data may additionally include frequency information, waveform information, current information, voltage information, and/or the like. For a 60 Hz electrical power system 10, the half-cycle input data may be updated at 120 Hz. In some embodiments, the SSO manager 100 may access the power quality data and utilize the half-cycle input data for SSO frequency analysis of the electrical power system 102.

Existing systems that attempt to monitor and/or mitigate SSO require the addition of supplementary sensors to a power distribution system, for instance, for detecting current, voltage, and/or other information. The addition of such supplementary sensors requires installation and maintenance costs. The supplementary sensors also require additional bandwidth and space in an already resource-intensive and space constrained environment. Furthermore, additional sensors and related equipment are often an additional source of power distribution issues and downtime.

The exemplary SSO management system 110 provides a technical solution by harnessing the existing information provided by power quality meters (PQMs) that are standard equipment in power distribution systems. Accordingly, rather than building SSO with supplementary AC voltage and current inputs, the exemplary SSO management system 110 is specially configured to use the half-cycle RMS voltage, current, and power values that are already available in a standard, existing power quality meter. In addition, by utilizing the power quality data already available, the SSO management system 110 eliminates a need to add supplementary sensors, measurement devices (for example and without limitation, phase measurement units, current transformers, voltage sensors) within the already crowded distribution network.

Conventional systems, including existing computer-based systems, are not able to use power quality data from a PQM to efficiently or accurately determine SSO. For example, the power quality data, including half-cycle data, is not able to be used by existing computer-based systems to provide information that facilitates the identification of any frequency below the fundamental frequency (e.g., 50 Hz or 60 Hz). However, a technical solution to this problem is solved by performing Fast Fourier Transform (FFT) on the power waveform information of the power quality data, such as half-cycle data, which decomposes the half-cycle input data into frequency components and facilitates the identification of any frequency below the fundamental frequency.

Existing computer-based methods, including FFT methods, for processing power waveform information are susceptible to spectral smearing that causes, among other things, the resulting information to exhibit inadequate precision. Accordingly, existing techniques are not able to process power quality data, including power waveform information, to provide accurate data for SSO determinations. However, processes according to some embodiments operate to provide a technical solution to this problem in the specific technical field of SSO monitoring and management by calculating an amplitude at each SSO frequency from a bin range, for instance, in order to compensate for the spectral smearing.

Existing computer-based systems are not able to adequately capture power waveform phenomena, including SSO, occurring in bursts as they may be missed by analysis windows. However, processes according to some embodiments operate to provide a technical solution to this problem through the implementation of a sliding window with multiple FFTs according to some embodiments.

Upon receiving the power quality data from the metering system 108, the SSO management system 110 performs a fast Fourier transform (FFT) with a frequency resolution target and peak detection in order to determine SSO via an efficient and accurate process. The SSO management system 110 performs an SSO analysis on the SSO phenomena based on the FFT. The results of the SSO analysis may be used to detect SSO and/or to control operation (including the control distribution apparatuses 106) based on the SSO.

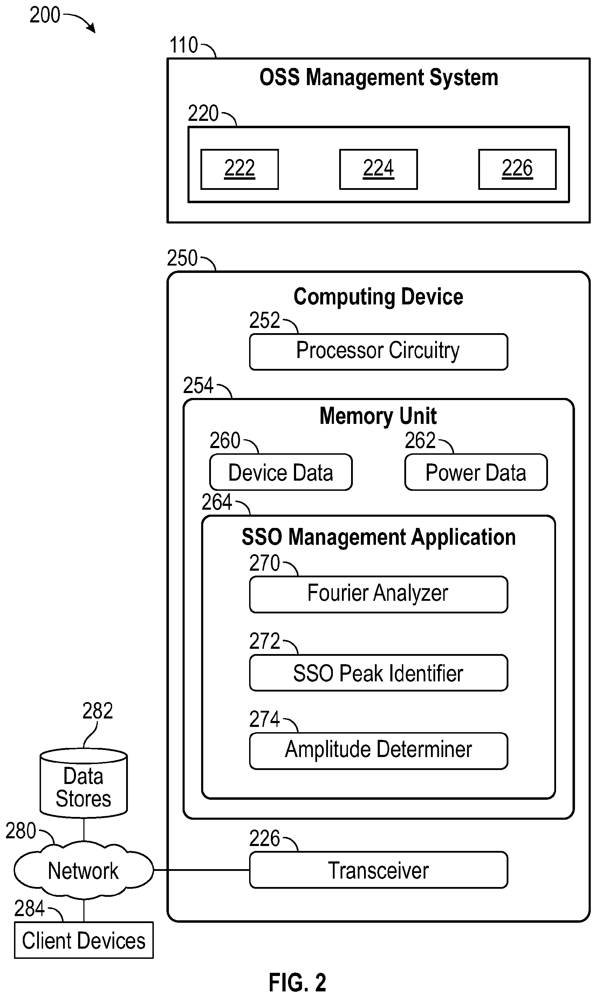

FIG. 2 depicts an illustrative example of an SSO management system in accordance with the present disclosure. In some embodiments, an SSO management system 110 may be a standalone system, such as a computing device 250. In various embodiments, the SSO management system 110 may be or may include a metering device 108. For example, the SSO management system 110 may be an embedded system of a metering device 108 or vice versa.

As shown in FIG. 2, an SSO management system 110 may include one or more control units 220. The control unit 220 may include a processor (or processing circuitry, a microcontroller, a controller, and/or the like) 222, memory 224, and/or a transceiver 226 (for instance, for wired or wireless communication). In some embodiments, the control unit 220 may be communicatively coupled to one or more metering devices 108 and/or to computing devices or storage for accessing the power information, such as power quality data.

In some embodiments, a computing device 250 may be communicatively coupled to the SSO management system 110. In various embodiments, the control unit 220 may be, may be the same as, or may be substantially the same as the computing device 250. For instance, the control unit 220 may include some or all of the functions and components of the computing device 250. In some embodiments, the SSO management system 110 may include the computing device 250 as an embedded control system (e.g., as the embedded control unit 220). In some embodiments, the computing device 250 may be a remote server computer or other type of computing device.

Although only one computing device 250 is depicted in FIG. 2, embodiments are not so limited. In various embodiments, the functions, operations, configurations, data storage functions, applications, logic, and/or the like described with respect to computing device 250 may be performed by and/or stored in one or more other computing devices (not shown), for example, coupled to computing device 250 via network 280 (for instance, one or more of client devices 284). A single computing device 250 is depicted for illustrative purposes only to simplify the figure. Embodiments are not limited in this context.

Computing device 250 may include a processor circuitry 252 that may include and/or may access various hardware and/or software logics for performing processes according to some embodiments. Processing circuitry 252 and/or portions thereof may be implemented in hardware, software, or a combination thereof. For example, a logic, circuitry, or a module may be and/or may include, but are not limited to, a process running on a processor, a processor, a hard disk drive, multiple storage drives (of optical and/or magnetic storage medium), an object, an executable, a thread of execution, a program, a computer, hardware circuitry, integrated circuits, a system-on-a-chip (SoC), memory units, logic gates, registers, semiconductor device, chips, microchips, chip sets, software components, programs, applications, firmware, software modules, computer code, a control loop, a computational model or application, an AI and/or ML model or application, variations thereof, combinations of any of the foregoing, and/or the like.

Memory unit 254 may include various types of computer-readable storage media and/or systems in the form of one or more memory units and/or storage media. In various embodiments, memory unit 254 may store various types of information and/or applications for the SSO management system 110 according to some embodiments. For example, memory unit 254 may store device data 260, power data 262, and/or an SSO management application 264. In various embodiments, some or all of the device data 260, power data 262, and/or the SSO management application 264 may be stored in one or more data stores 282 accessible to computing device 250 via network 280. For example, one or more of data stores 282 may be or may include historical data, a proprietary database, manufacturer information, device operating information, and/or the like.

The device data 260 may be or may include information associated with devices of the electrical power system 102. The devices may include a distribution apparatus 106. The devices may include a damping system. The device data 260 may include operating parameters, frequency ranges, power information, historical SSO data, and/or the like.

Power data 262 may include power information measured by the metering system 108, such as by one or more PQMs. In some embodiments, the power data 262 may include power quality data such as RMS voltage, current, and power with half-cycle updates (e.g., half-cycle input data), frequency information, waveform information, current information, voltage information, and/or the like.

The SSO management application 264 may be configured to perform operational aspects of the SSO management system 110 according to various embodiments. The SSO management application 264 may perform software functions by being executed via processer circuitry 252 and/or 222. For example, the SSO management application 264 may receive, process, and/or store power data 262. In various embodiments, the SSO management application 264 may operate to provide a user interface (alone or in combination with the client devices 284). For example, the SSO management application 264 may provide SSO information, power quality data, SSO-based alerts and messages, and/or the like to the client devices 284. In various embodiments, the client devices 284 may be or may include embedded computer systems (for instance, an embedded display and/or input devices), a mobile computing device (for instance, a mobile phone, a tablet computing device, a laptop computing device, and/or the like), a workstation, a PC, a server, and/or the like. Accordingly, a user may receive SSO information generated via the SSO management system 110 from the SSO management application 264.

In various embodiments, the SSO management application 264 may include various hardware and/or software modules configured to perform various operational aspects of processes according to some embodiments.

In some embodiments, the modules may include a Fourier analyzer 270, an SSO peak identifier 272, and an amplitude determiner 274. The Fourier analyzer 270 may operate to receive the half-cycle input data from the metering system 108 and perform Fourier analysis on the half-cycle input data based on a predetermined resolution target. The predetermined resolution target may be set by a user. In some embodiments, the resolution target may be about 0.1 Hz. In some embodiments, the resolution target may be less than about 0.1 Hz. In some embodiments, the resolution target may be about 0.05 Hz to about 5 Hz. In various embodiments, the resolution target may be about 0.05 Hz, about 0.1 Hz, about 0.5 Hz, about 1 Hz, about 2 Hz, about 5 Hz, about 10 Hz, about 20 Hz, greater than about 20 Hz, and any value or range between any two of these values (including endpoints).

The Fourier analysis may include Fast Fourier Transform (FFT), which decomposes the half-cycle input data into frequency components and facilitates the identification of any frequency below the fundamental frequency (e.g., 50 Hz or 60 Hz) of the electrical power system 10, for example and without limitation, an SSO. The Fourier analyzer 270 analyzes the half-cycle input data (for example and without limitation, a half-cycle system power average) using an n-point FFT, for example, computing a discrete FFT of a sequence of n samples, producing n frequency domain points or bins. In various embodiments, n may be selected based on the frequency resolution. In some embodiments, n may be about 2048. In various embodiments, n may be about 100 to about 5000. In some embodiments, n may be about 100, about 200, about 500, about 1000, about 1024, about 2000, about 2048, about 3000, about 4000, about 5000, greater than 5000, and any value or range between any two of these values (including endpoints).

In some embodiments, the Fourier analyzer 270 may use a 2048-point FFT on an average power waveform over a latest time window. In some embodiments, the time window may be about 17 seconds. In various embodiments, the time window may be about 17.1 seconds. In some embodiments, the time window may be about 5 seconds to about 30 seconds. In various embodiments, the time window may be about 5 seconds, about 10 seconds, about 15 seconds, about 17 seconds, about 20 seconds, about 25 seconds, about 30 seconds, about 60 seconds, about 120 seconds, about 300 seconds, and any value or range between any two of these values (including endpoints).

For example, in some embodiments, the Fourier analyzer 270 uses 2048 discrete frequency components (bins) into which the FFT algorithm divides the original time-domain signal points. The use of 2048-point FFT allows the SSO management system 110 to satisfy or surpass the predetermined resolution target (for instance, 0.1 Hz). A 2048-point FFT analysis results in 0.0586 Hz resolution (i.e., 120/2048), surpassing a 0.1 Hz resolution target.

The SSO peak identifier 272 operates to identify one or more peaks above a threshold from the FFT bins. The threshold may be predetermined and may include FFT bins within a detection range of interest. In some embodiment, the range of interest may be about 2 Hz. In various embodiments, the range of interest may be about 12 Hz. In some embodiments, the range of interest may be about 2 Hz to about 12 Hz. In some embodiments, the range of interest may be about 3 Hz to about 12 Hz. In various embodiments, the range of interest may be about 2 Hz to about 20 Hz. In one non-limiting example, bins 34-340 for 2-20 Hz on a 60 Hz power system may be identified.

The amplitude determiner 274 operates to calculate an amplitude at each SSO frequency from a bin range, for instance, in order to compensate for spectral smearing. In some embodiments, the bin range may be 7 bins. In various embodiments, the bin range may be about 2 bins to about 7 bins. In some embodiments, the bin range may be about 5 bins to about 20 bins. In some embodiments, the bin range may be about 5 bins to about 100 bins. In one non-limiting example, the peaks are calculated from a bin $n$ and a number of neighboring or surrounding bins (for example and without limitation, 6 surrounding bins), $n$-3, $n$-2, $n$-1, $n$, $n$+1, $n$+2 and $n$+3. The amplitude at each SSO frequency is calculated according to the following Equation (1):

$$Amplitude = \sqrt{b^2_{(n-3)} + b^2_{(n-2)} + b^2_{(n-1)} + b^2_{(n)} + b^2_{(n+1)} + b^2_{(n+2)} + b^2_{(n+3)}},$$

where $b$ refers to a bin and $n$ refers to a bin index. For example, a bandwidth of 0.176 Hz (~0.35 Hz) may be used around the detected peak oscillation. The example of Equation (1) is provided for 6 surrounding bins; more or fewer b terms in Equation (1) are required depending on the number of surrounding bins.

The detected oscillation can be directly calculated from power information updated at half-cycles or indirectly calculated from the voltage and current spectrums. The power and direction are calculated from these selected voltage and current frequencies. Although Fourier analysis presumes repetitive waveforms, likely scenarios have oscillations that come and go within the, for example, 17 second input window. For instance, there could be a plurality of oscillatory bursts, each lasting several seconds. To capture the entirety of the bursts, a sliding window with multiple FFTs may be used. In some embodiments, the sliding window may be about 5 seconds. In various embodiments, the sliding window may be about 2 seconds to about 10 seconds. For instance, with every 5 second sliding window, an FFT can be performed on 17 seconds of data, assuring that the phenomena are correctly characterized.

In operation, the SSO management system 110 continuously monitors SSO at the point of common coupling (PCC) of the electrical power system 102. For example, the SSO management system 110 receives the half-cycle input data from the metering system 108 and performs an FFT based on the predetermined resolution target. In some embodiments, resonances between 2 Hz and 12 Hz may be defined as the range of interest by the SSO management system 110. The 2 Hz to 12 Hz range may be of particular interest due to the added complications from datacenters and renewable systems.

In one non-limiting example, the SSO management system 110 monitors SSO within a range of interest, for example and without limitation, between 2 Hz and 20 Hz. The SSO management system 110 performs a 2048-point FFT on the power waveform over the latest time window. The SSO management system 110 then identifies peaks above a defined peak threshold from FFT bins within the range of interest (for example and without limitation, bins 34-340 for 2-20 Hz on a 60 Hz power system). The SSO management system 110 next calculates amplitude at each SSO frequency from a bin range (for example and without limitation, 7 bins) in order to compensate for spectral smearing in accordance with the Equation (1).

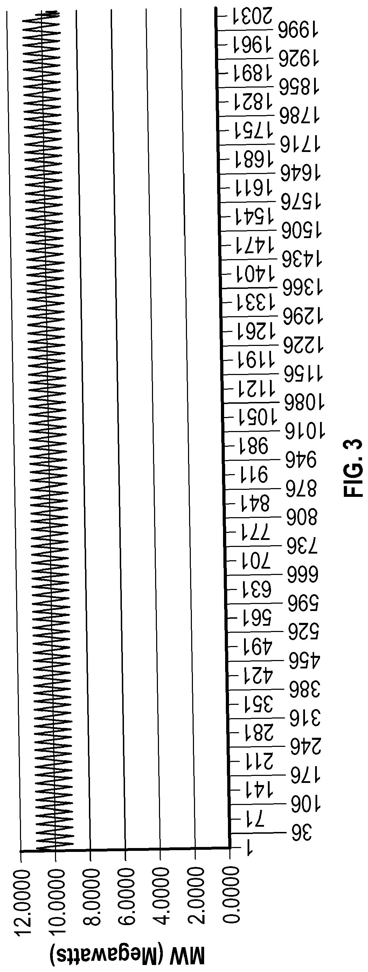

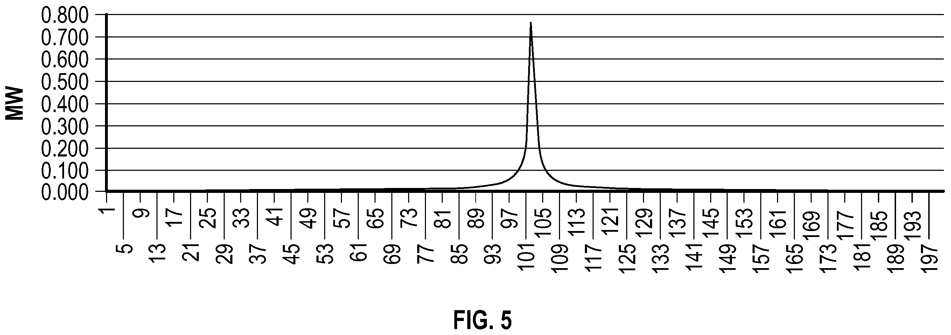

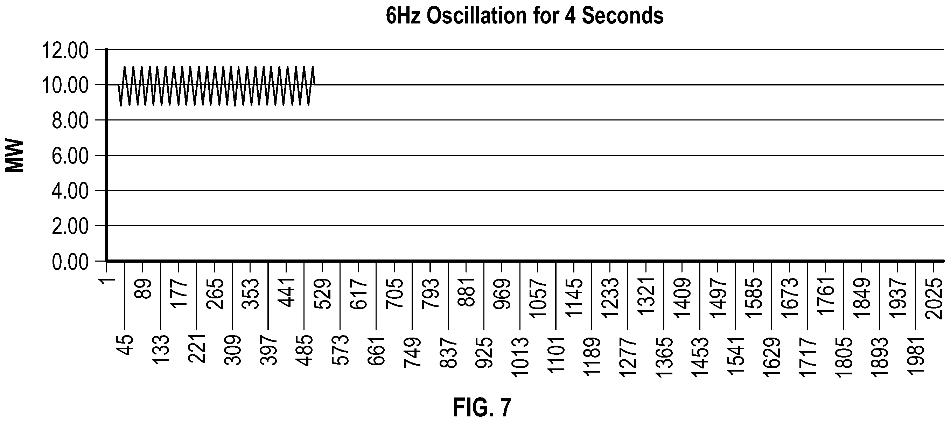

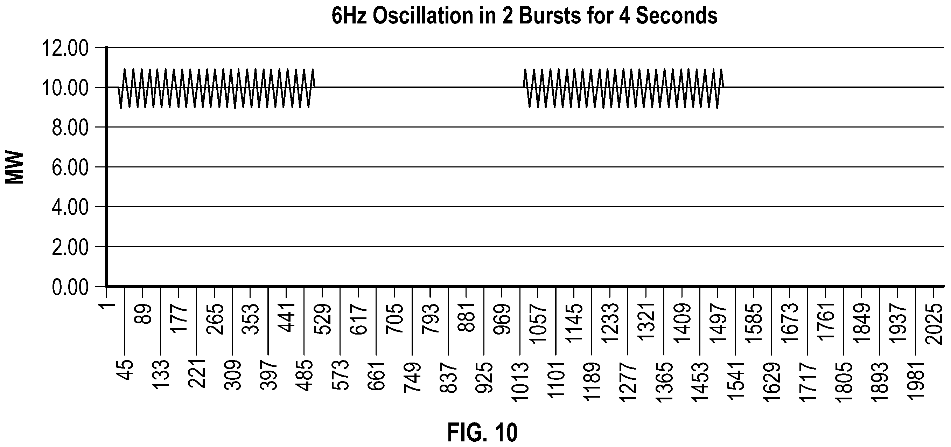

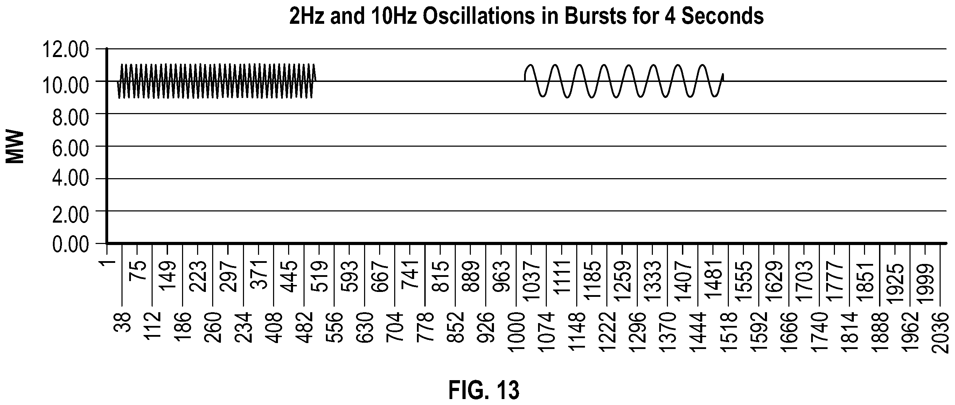

FIGS. 3-16 illustrate various examples of detected SSO for a 60 Hz electrical power system 102 using processes performed by an SSO management system 110 according to various embodiments. More specifically, FIGS. 3-6 graphically depict a non-limiting example of continuous SSO detection within the electrical power system 102, FIGS. 7-9 graphically depict a non-limiting example of a burst of SSO detected within the electrical power system 102, FIGS. 10-12 graphically depict a non-limiting example of a plurality of SSO bursts detected within the electrical power system 102, and FIGS. 13-16 graphically depict a non-limiting example of a plurality of bursts having different SSO frequencies detected within the electrical power system 102.

Referring to FIGS. 3-6, depicted therein are graphical illustrations relating to the SSO management system 110 detecting the electrical power system 102 having an average system power of 10 MW (megawatts) with a continuous SSO of 1 MW at 6 Hz.

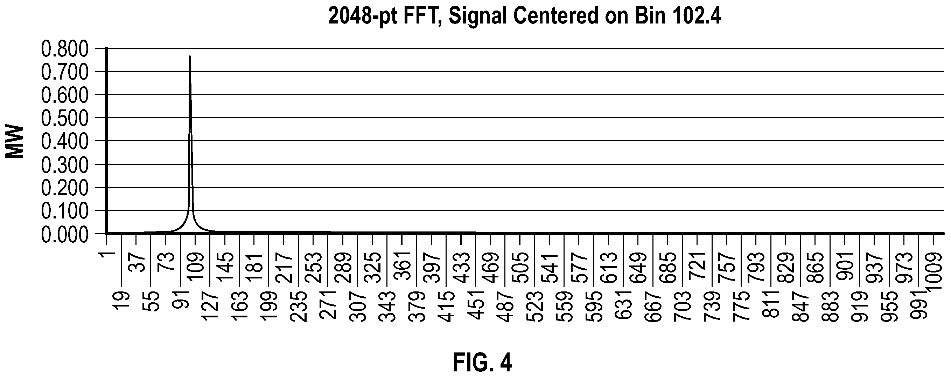

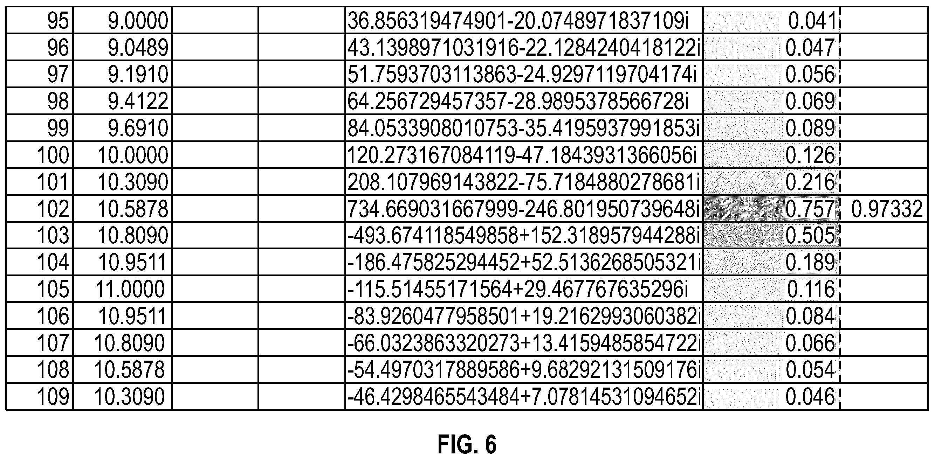

FIG. 3 illustrates an input power waveform having 10 MW average system power. Half-cycle power is updated at a rate of 120 Hz, feeding the input to a 2048-point FFT. FIG. 4 shows that since the FFT resolution is 120/2048 (0.0586 Hz), the 6 Hz oscillation is not centered at a discrete bin, but centered at 2048/120*6 (bin 102.4). The peak FFT bin is at 102 with an amplitude of 0.76 MW (below the expected 1 MW) as shown in FIGS. 4-6. However, as shown in FIG. 6, by including the RMS of the adjacent bins, the amplitude is 0.97 MW (within 3% of expectations). In addition, FIG. 6 shows a plurality of bins including the bin number 102 having the oscillation peak as well as the adjacent 6 bins, with the amplitude being calculated according to Equation (1). Furthermore, with constant oscillations, each FFT with the sliding input data provides identical results.

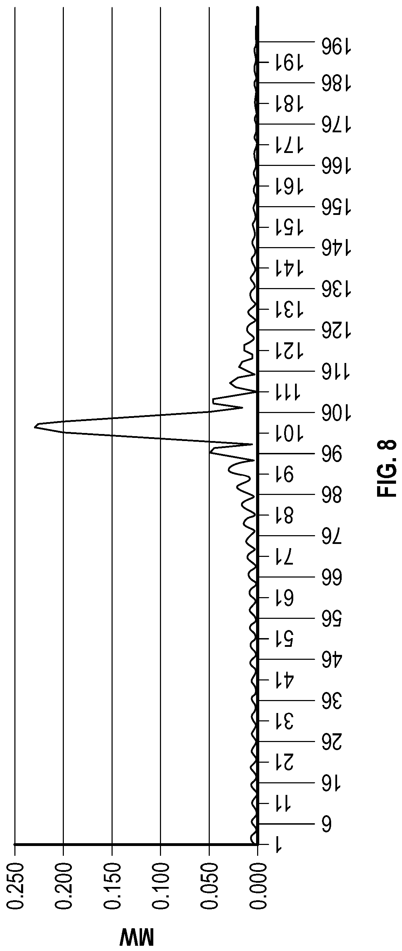

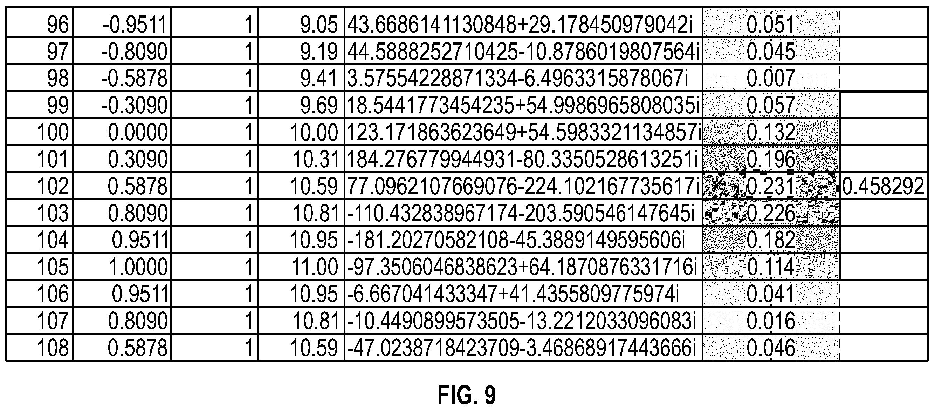

FIGS. 7-9 illustrate an additional scenario with the same 60 Hz electrical power system 102 with SSO being a burst or in bursts. FIG. 7 shows the electrical power system 102 having an average system power of 10 MW with a 6 Hz oscillation being a burst with a 4-second duration. FIG. 8 shows that the SSO peak is centered at bin 102.4. The oscillation amplitude is 1.0 MW, but present for only 4 of the 17 seconds (23.5%). Despite the oscillation not being centered on a discrete bin, the spectrum is approximately correct. For example, the spectrum amplitude including the RMS values of the adjacent bins is 0.458292, which is close to the oscillation magnitude of 0.5878 MW at bin 102 as shown in FIG. 9. In addition, with the burst, it is possible that the input data is split at the beginning or end of a 17-second window. Nevertheless, with the use of a sliding window (for instance, 5-second updates), at least one FFT result captures the entire burst.

Although FIGS. 3-9 show SSO frequency at 6 Hz, this is for illustrative purposes only, and the SSO frequency may be any other frequences within the range of interest (for example and without limitation, 2 - 20 Hz).

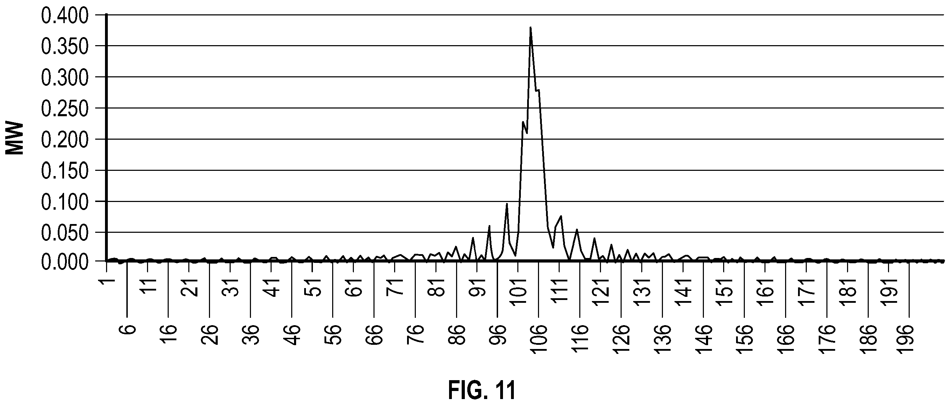

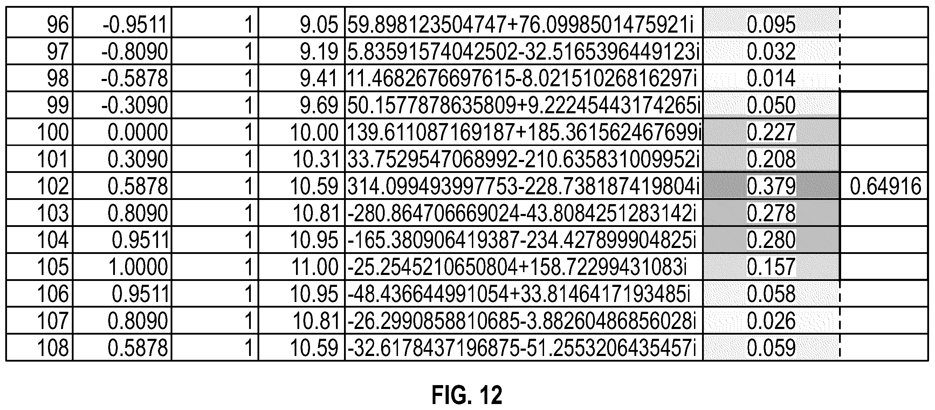

FIGS. 10-12 illustrate another scenario in which the 60 Hz electrical power system 102 has multiple bursts occurring within the 17-second input data. FIG. 10 shows two 4-second bursts of 6 Hz oscillations. The oscillation amplitude is 1.0 MW, but present for only 8 of the 17 seconds (47%). Unlike a single burst, the asynchronous bursts result in smearing that is centered about bin 102.4, as shown in FIGS. 11 and 12.

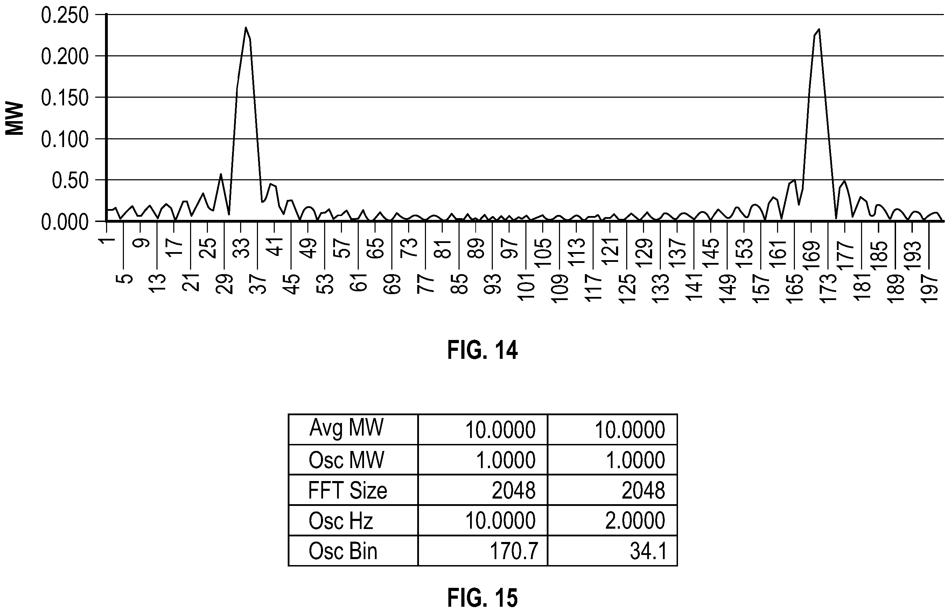

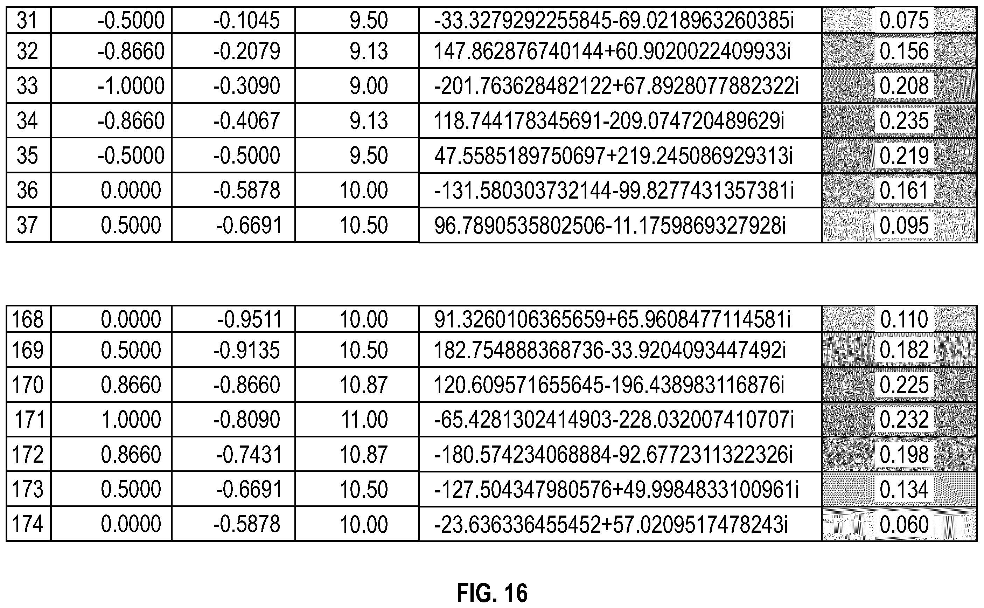

FIGS. 13-16 illustrate another scenario in which the 60 Hz electrical power system 102 has bursts of different SSOs within the 17-second input data. FIG. 13 shows a 4-second burst of 2 Hz and a 4-second burst of 10 Hz. Although FIGS. 13-16 illustrate two 4-second bursts of 2 Hz and 10 Hz, this is for illustrative purposes only, and each burst can be of different frequencies and/or durations. The SSOs are not centered on discrete bins, the 2 Hz SSO is centered on bin 34.1 and the 10 Hz SSO is centered on bin 170.7, as shown in FIG. 15. The SSO management system 110 accurately captures the peak of each frequency as shown in FIGS. 14 and 16.

Accordingly, rather than building SSO from AC voltage and current inputs, the exemplary SSO management system 110 allows the use of the already available half-cycle input data from the existing metering system 108 in detecting and analyzing SSO in an electrical power system 102. In addition, by calculating amplitudes at each SSO frequency, the SSO management system 110 allows for compensation of spectral smearing. In addition, the SSO management system 110 is able to capture the entirety of a plurality of oscillatory bursts by using a sliding window with multiple FFTs. Furthermore, the SSO management system 110 can accurately capture oscillatory peaks of a plurality of bursts having different SSO frequencies by, for example and without limitation, including the RMS values of the adjacent bins and the use of sliding windows for the calculation of the SSO frequency amplitude.

Included herein are one or more logic flows representative of exemplary methodologies for performing novel aspects of the disclosed architecture. While, for purposes of simplicity of explanation, the one or more methodologies shown herein are shown and described as a series of acts or steps, those skilled in the art will understand and appreciate that the methodologies are not limited by the order of acts. Some acts may, in accordance therewith, occur in a different order and/or concurrently with other acts from that shown and described herein. For example, those skilled in the art will understand and appreciate that a methodology could alternatively be represented as a series of interrelated states or events, such as in a state diagram. Moreover, not all acts illustrated in a methodology may be required for a novel implementation.

A logic flow may be implemented in software, firmware, hardware, or any combination thereof. A logic flow may be implemented by computer executable instructions stored on a non-transitory computer readable medium or machine readable medium. A logic flow may be performed by the SSO management system 110, the control unit 220, and/or the computing device 250. The embodiments are not limited in this context.

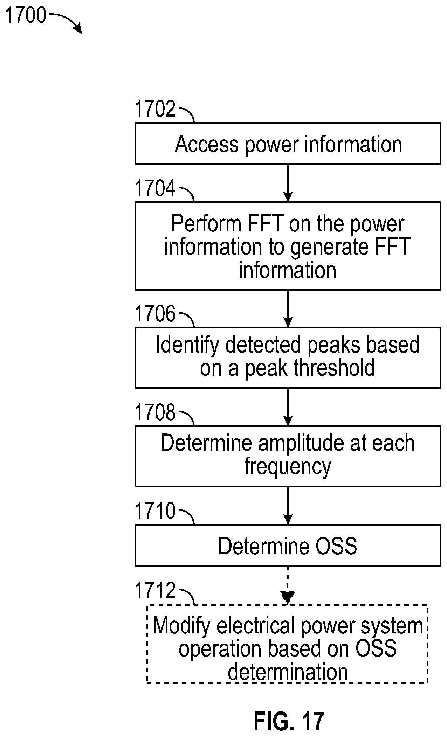

FIG. 17 illustrates a logic flow in accordance with the present disclosure. The logic flow 1700 may be representative of some or all of the operations executed by one or more embodiments described herein, such as the SSO management system 110, the control unit 220, and/or the computing device 250. In some embodiments, the logic flow 1700 may be representative of some or all of the operations of a method of SSO detection and management according to the present disclosure.

At block 1702, the logic flow 1700 may access power information. For example, the SSO management system 110 may access power information of the electrical power distribution network 104 measured via a metering system 108. In some embodiments, the power information may include power waveform information measured via a PQM (see, for example, FIGS. 3-16).

The logic flow 1700 may perform FFT on the power information to generate FFT information at block 1704. For example, the Fourier analyzer 270 analyzes the half-cycle input data (for example and without limitation, a half-cycle system power average) using an n-point FFT, for example, computing a discrete FFT of a sequence of n samples, producing n frequency domain points or bins. In some embodiments, n may be 2048. In some embodiments, the Fourier analyzer 270 may use a 2048-point FFT on an average power waveform over a latest time window. In some embodiments, the time window may be about 17 seconds

At block 1706, the logic flow 1700 may identify detected peaks based on a peak threshold. For example, the SSO peak identifier 272 operates to identify one or more peaks above a threshold from the FFT bins. The threshold may be predetermined and may include FFT bins within a detection range of interest. In one non-limiting example, bins 34-340 for 2-20 Hz on a 60 Hz power system may be identified.

At block 1708, the logic flow 1700 may determine amplitude at each frequency. For example, the amplitude determiner 274 may be executed to calculate amplitude at each SSO frequency from a bin range, for instance, in order to compensate for spectral smearing using Equation (1).

The logic flow 1700 may determine SSO at block 1710. For example, a detected oscillation can be directly calculated from power information updated at half-cycles or indirectly calculated from the voltage and current spectrums. The power and direction are calculated from these selected voltage and current frequencies

At optional block 1712, the logic flow 1700 may modify electrical power system operation based on the SSO determination. For example, the SSO management system 110 may be operably coupled to one or more control devices for the electrical power system 102. The SSO management system 110 may instruct the control devices to change operational parameters and/or operation of a device based on the detected SSO. The location/source of the SSO may be determined by the SSO management system 110 based on various processes, for instance, via power information source identifiers or metadata, a source/location of the power information that was used to determine an SSO, and/or the like. The SSO management system 110 directly or through the control devices may control a distribution apparatus 106 based on the SSO to mitigate or even eliminate the SSO. The SSO management system 110 directly or through the control devices may control a damping system in response to detected SSO (for instance, to introduce negative damping effects) to mitigate or even eliminate the SSO. In another example, the SSO management system 110 directly or through the control devices may control Static Synchronous Compensators (STATCOMs), Doubly-Fed Induction Generators (DFIGs) (for instance, with supplementary damping controllers), Modular Multilevel Converter (MMC)-HVDC systems, and/or generator excitation systems in response to detected SSO to mitigate or even eliminate the SSO. In an additional example, the SSO management system 110 directly or through the control devices may control an inverter associated with the SSO to mitigate or even eliminate the SSO. In a further example, the SSO management system 110 directly or through the control devices may control a converter associated with the SSO to mitigate or even eliminate the SSO. In a further example, the SSO management system 110 directly or through the control devices may perform parameter tuning for devices and/or systems associated with the SSO to mitigate or even eliminate the SSO.

While specific embodiments have been described in the present disclosure, it will be appreciated by those skilled in the art that various modifications and alternatives to the described embodiments could be developed in light of the overall teachings of the disclosure. Accordingly, the particular arrangements disclosed are meant to be illustrative only and not limiting as to the scope of the disclosed embodiments which are to be given the full breadth of the claims appended and any and all equivalents thereof.

**Claims**

1. An electrical power system, comprising:

a plurality of electrical distribution equipment configured to distribute power between at least one power source and a plurality of loads;

a power quality meter configured to measure power quality data for power distributed via the plurality of electrical distribution equipment; and

a sub-synchronous oscillation (SSO) management system operative to detect SSO within the electrical power system, the SSO management system operative to:

access power waveform information of the power quality data,

perform Fast Fourier transform (FFT) on the power waveform over a time window for a resolution target for a number of samples to compute FFT information comprising a plurality of frequency domain bins comprising a bin for each of the number of samples,

identify at least one SSO peak above a peak threshold from the frequency domain bins, and

determine a presence of SSO based on the at least one SSO peak.

2. The electrical power system of claim 1, wherein the at least one SSO peak is identified within a range of bins of the plurality of frequency domain bins based on a frequency range of interest.

3. The electrical power system of one of claim 1 or 2, wherein the frequency range of interest is about 2 Hz to about 20 Hz.

4. The electrical power system of one of claims 1-3, wherein the power quality data comprises half-cycle input data including half-cycle RMS voltage data, half-cycle RMS current data, and half-cycle RMS power data.

5. The electrical power system of one of claims 1-4, wherein the SSO management system is operative to calculate an amplitude at each SSO frequency from a bin range of the plurality of frequency domain bins.

6. The electrical power system of one of claims 1-5, wherein the amplitude comprises root mean square (RMS) values from a plurality of surrounding FFT bins within the bin range.

7. The electrical power system of one of claims 1-6, wherein the number of samples is based on the resolution target.

8. The electrical power system of one of claims 1-7, wherein a plurality of FFTs are performed over a sliding window to determine SSO bursts.

9. The electrical power system of one of claims 1-8, wherein the SSO management system is operative to control the operation of a distribution appliance to mitigate SSO.

10. A sub-synchronous oscillation (SSO) management system, comprising:

at least one memory storing instructions; and

at least one processor circuitry, communicatively coupled to the at least one memory, operative to execute the instructions to:

access power waveform information of the power quality data,

perform Fast Fourier transform (FFT) on the power waveform over a time window for a resolution target for a number of samples to compute FFT information comprising a plurality of frequency domain bins comprising a bin for each of the number of samples,

identify at least one SSO peak above a peak threshold from the frequency domain bins, and

determine a presence of SSO based on the at least one SSO peak.

11. The SSO management system of claim 10, wherein the power quality data comprises half-cycle input data including half-cycle RMS voltage data, half-cycle RMS current data, and half-cycle RMS power data.

12. The SSO management system of one of claims 10 or 11, wherein the at least one processor circuitry is operative to execute the instructions to control the operation of a distribution appliance to mitigate SSO.

13. The SSO management system of one of claims 10-12, wherein the SSO management system is operative to calculate an amplitude at each SSO frequency from a bin range of the plurality of frequency domain bins.

**14.** The SSO management system of one of claims 10-13, wherein the amplitude comprises root mean square (RMS) values from a plurality of surrounding FFT bins within the bin range.

**15.** The SSO management system of one of claims 10-14, wherein the number of samples is based on the resolution target.

100

102

**Electrical Power System**

104

**Electrical Power Distribution Network**

108

Metering System

110

OSS Management System

108

Source

112

106

Distribution Apparatus

114a

Load

114n

Load

**FIG. 1**

200

**110**

## OSS Management System

**220**

| 222 | 224 | 226 |

**250**

## Computing Device

**252**
Processor Circuitry

**254**

### Memory Unit

**260**
Device Data

**262**
Power Data

**264**

#### SSO Management Application

**270**
Fourier Analyzer

**272**
SSO Peak Identifier

**274**
Amplitude Determiner

**282**
Data Stores

**280**
Network

**284**
Client Devices

**226**
Transceiver

**FIG. 2**

FIG. 3

2048-pt FFT, Signal Centered on Bin 102.4

FIG. 4

EP 4 746 226 A1

**FIG. 5**

| | | | | | | |
|---|---|---|---|---|---|---|
| 95 | 9.0000 | | | 36.856319474901-20.0748971837109i | 0.041 | |
| 96 | 9.0489 | | | 43.1398971031916-22.1284240418122i | 0.047 | |
| 97 | 9.1910 | | | 51.7593703113863-24.9297119704174i | 0.056 | |
| 98 | 9.4122 | | | 64.256729457357-28.9895378566728i | 0.069 | |
| 99 | 9.6910 | | | 84.0533908010753-35.4195937991853i | 0.089 | |
| 100 | 10.0000 | | | 120.273167084119-47.1843931366056i | 0.126 | |
| 101 | 10.3090 | | | 208.107969143822-75.7184880278681i | 0.216 | |
| 102 | 10.5878 | | | 734.669031667999-246.801950739648i | 0.757 | 0.97332 |
| 103 | 10.8090 | | | -493.674118549858+152.318957944288i | 0.505 | |
| 104 | 10.9511 | | | -186.475825294452+52.5136268505321i | 0.189 | |
| 105 | 11.0000 | | | -115.51455171564+29.467767635296i | 0.116 | |
| 106 | 10.9511 | | | -83.9260477958501+19.2162993060382i | 0.084 | |
| 107 | 10.8090 | | | -66.0323863320273+13.4159485854722i | 0.066 | |
| 108 | 10.5878 | | | -54.4970317889586+9.68292131509176i | 0.054 | |
| 109 | 10.3090 | | | -46.4298465543484+7.07814531094652i | 0.046 | |

FIG. 6

EP 4 746 226 A1

6Hz Oscillation for 4 Seconds

FIG. 7

EP 4 746 226 A1

FIG. 8

| | | | | | | |
|---|---|---|---|---|---|---|
| 96 | -0.9511 | 1 | 9.05 | 43.6686141130848+29.178450979042i | 0.051 | |
| 97 | -0.8090 | 1 | 9.19 | 44.5888252710425-10.8786019807564i | 0.045 | |
| 98 | -0.5878 | 1 | 9.41 | 3.57554228871334-6.49633315878067i | 0.007 | |
| 99 | -0.3090 | 1 | 9.69 | 18.5441773454235+54.9986965808035i | 0.057 | |
| 100 | 0.0000 | 1 | 10.00 | 123.171863623649+54.5983321134857i | 0.132 | |
| 101 | 0.3090 | 1 | 10.31 | 184.276779944931-80.3350528613251i | 0.196 | |
| 102 | 0.5878 | 1 | 10.59 | 77.0962107669076-224.102167735617i | 0.231 | 0.458292 |
| 103 | 0.8090 | 1 | 10.81 | -110.432838967174-203.590546147645i | 0.226 | |
| 104 | 0.9511 | 1 | 10.95 | -181.20270582108-45.3889149595606i | 0.182 | |
| 105 | 1.0000 | 1 | 11.00 | -97.3506046838623+64.1870876331716i | 0.114 | |
| 106 | 0.9511 | 1 | 10.95 | -6.667041433347+41.4355809775974i | 0.041 | |
| 107 | 0.8090 | 1 | 10.81 | -10.4490899573505-13.2212033096083i | 0.016 | |
| 108 | 0.5878 | 1 | 10.59 | -47.0238718423709-3.46868917443666i | 0.046 | |

FIG. 9

EP 4 746 226 A1

6Hz Oscillation in 2 Bursts for 4 Seconds

FIG. 10

EP 4 746 226 A1

FIG. 11

| 96 | -0.9511 | 1 | 9.05 | 59.898123504747+76.09985014759211i | 0.095 | |
|---|---|---|---|---|---|---|
| 97 | -0.8090 | 1 | 9.19 | 5.83591574042502-32.5165396449123i | 0.032 | |
| 98 | -0.5878 | 1 | 9.41 | 11.4682676697615-8.02151026816297i | 0.014 | |
| 99 | -0.3090 | 1 | 9.69 | 50.1577878635809+9.22245443174265i | 0.050 | |
| 100 | 0.0000 | 1 | 10.00 | 139.611087169187+185.361562467699i | 0.227 | |
| 101 | 0.3090 | 1 | 10.31 | 33.7529547068992-210.635831009952i | 0.208 | |
| 102 | 0.5878 | 1 | 10.59 | 314.099493997753-228.738187419804i | 0.379 | 0.64916 |
| 103 | 0.8090 | 1 | 10.81 | -280.864706669024-43.8084251283142i | 0.278 | |
| 104 | 0.9511 | 1 | 10.95 | -165.380906419387-234.427899904825i | 0.280 | |
| 105 | 1.0000 | 1 | 11.00 | -25.2545210650804+158.72299431083i | 0.157 | |
| 106 | 0.9511 | 1 | 10.95 | -48.436644991054+33.8146417193485i | 0.058 | |
| 107 | 0.8090 | 1 | 10.81 | -26.2990858810685-3.88260486856028i | 0.026 | |
| 108 | 0.5878 | 1 | 10.59 | -32.6178437196875-51.2553206435457i | 0.059 | |

**FIG. 12**

EP 4 746 226 A1

2Hz and 10Hz Oscillations in Bursts for 4 Seconds

FIG. 13

EP 4 746 226 A1

**FIG. 14**

| | | |
|---|---|---|
| Avg MW | 10.0000 | 10.0000 |
| Osc MW | 1.0000 | 1.0000 |
| FFT Size | 2048 | 2048 |
| Osc Hz | 10.0000 | 2.0000 |
| Osc Bin | 170.7 | 34.1 |

**FIG. 15**

EP 4 746 226 A1

| 31 | -0.5000 | -0.1045 | 9.50 | -33.3279292255845-69.0218963260385i | 0.075 |
| 32 | -0.8660 | -0.2079 | 9.13 | 147.862876740144+60.9020022409933i | 0.156 |
| 33 | -1.0000 | -0.3090 | 9.00 | -201.763628482122+67.8928077882322i | 0.208 |
| 34 | -0.8660 | -0.4067 | 9.13 | 118.744178345691-209.074720489629i | 0.235 |
| 35 | -0.5000 | -0.5000 | 9.50 | 47.5585189750697+219.245086929313i | 0.219 |
| 36 | 0.0000 | -0.5878 | 10.00 | -131.580303732144-99.8277431357381i | 0.161 |
| 37 | 0.5000 | -0.6691 | 10.50 | 96.7890535802506-11.1759869327928i | 0.095 |

| 168 | 0.0000 | -0.9511 | 10.00 | 91.3260106365659+65.9608477114581i | 0.110 |
| 169 | 0.5000 | -0.9135 | 10.50 | 182.754888368736-33.9204093447492i | 0.182 |
| 170 | 0.8660 | -0.8660 | 10.87 | 120.609571655645-196.438983116876i | 0.225 |
| 171 | 1.0000 | -0.8090 | 11.00 | -65.4281302414903-228.032007410707i | 0.232 |
| 172 | 0.8660 | -0.7431 | 10.87 | -180.574234068884-92.6772311322326i | 0.198 |
| 173 | 0.5000 | -0.6691 | 10.50 | -127.504347980576+49.9984833100961i | 0.134 |
| 174 | 0.0000 | -0.5878 | 10.00 | -23.636336455452+57.0209517478243i | 0.060 |

FIG. 16

EP 4 746 226 A1

1700

1702

Access power information

1704

Perform FFT on the power information to generate FFT information

1706

Identify detected peaks based on a peak threshold

1708

Determine amplitude at each frequency

1710

Determine OSS

1712

Modify electrical power system operation based on OSS determination

**FIG. 17**

| Europäisches Patentamt European Patent Office Office européen des brevets | **EUROPEAN SEARCH REPORT** | Application Number EP 25 19 9812 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CN 105 606 895 A (STATE GRID CORP CHINA ET AL.) 25 May 2016 (2016-05-25) * paragraph [0041] - paragraph [0046] * ----- | 1-15 | INV. H02J3/01 G01R19/25 G06F17/14 |
| Y | CN 112 611 968 A (GUANGZHOU POWER SUPPLY BUREAU GUANGDONG POWER GRID CO LTD ET AL.) 6 April 2021 (2021-04-06) * paragraph [0058] - paragraph [0070] * ----- | 1-15 | H02J13/12 |

TECHNICAL FIELDS SEARCHED (IPC)

H02J
G01R
G06F

The present search report has been drawn up for all claims

| Place of search | Date of completion of the search | Examiner |
|---|---|---|
| Munich | 1 April 2026 | Martin, Raynald |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 9812

This annex lists the patent family members relating to the patent documents cited in the above-mentioned European search report.
The members are as contained in the European Patent Office EDP file on
The European Patent Office is in no way liable for these particulars which are merely given for the purpose of information.

01-04-2026

| Patent document cited in search report | | Publication date | Patent family member(s) | Publication date |
|---|---|---|---|---|
| CN 105606895 | A | 25-05-2016 | NONE | |
| CN 112611968 | A | 06-04-2021 | NONE | |

EPO FORM P0459

For more details about this annex : see Official Journal of the European Patent Office, No. 12/82

**REFERENCES CITED IN THE DESCRIPTION**

**Patent documents cited in the description**

- US 63690000